# EUROPEAN PATENT APPLICATION

(11) **EP 4 722 852 A1**
(43) Date of publication of application: **08.04.2026**
(21) Application number: 24843579.4
(22) Date of filing: 17.05.2024
(51) Int. Cl.: G06F 1/16, H05K 1/14, H05K 5/02

(54) **FOLDABLE ELECTRONIC DEVICE COMPRISING PRINTED CIRCUIT BOARD**

(30) Priority: 20.07.2023 KR 20230094231; 26.07.2023 KR 20230097749; 29.11.2023 KR 20230169241
(71) Applicant: Samsung Electronics Co., Ltd., Suwon-si, Gyeonggi-do 16677 (KR)
(72) Inventor: KWON, Kihwan, Suwon-si, Gyeonggi-do 16677 (KR); CHO, Sujin, Suwon-si, Gyeonggi-do 16677 (KR); KIM, Youngseok, Suwon-si, Gyeonggi-do 16677 (KR); LEE, Jaewoo, Suwon-si, Gyeonggi-do 16677 (KR); CHUN, Woosung, Suwon-si, Gyeonggi-do 16677 (KR)
(74) Representative: HGF
(86) International application number: PCT/KR2024/095819
(87) International publication number: WO 2025/018868

(57) **Abstract**

A foldable electronic device, according to various embodiments of the present invention, includes: a hinge module; a first housing at least partially coupled to a first side of the hinge module and including a first support member and a first printed circuit board; a first through-hole formed in the first support member; a second housing at least partially coupled to a second side of the hinge module and including a second support member and a second printed circuit board; a second through-hole formed in the second support member; and a conductive connection member electrically connecting the first printed circuit board and the second printed circuit board through the first through-hole and the second through-hole, wherein the first support member includes a recess, and a portion of the first printed circuit board is disposed in the recess.

## Description

### [Technical Field]

Various embodiments of the disclosure relate to a foldable electronic device including at least one printed circuit board.

### [Background Art]

The use of foldable electronic devices capable of being folded and unfolded in a horizontal or vertical direction is increasing, and various functions are being provided in such foldable electronic devices.

The foldable electronic device may operate in a folded state or an unfolded state, with a first housing and a second housing configured to move around a hinge module.

The foldable electronic device may operate in an in-folding and/or out-folding manner by rotating the first housing and the second housing using the hinge module.

### [Disclosure of Invention]

### [Technical Problem]

A foldable electronic device may include a flexible display disposed at least partially across a first housing, a hinge module, and a second housing.

In the foldable electronic device, when the first housing and the second housing are folded using the hinge module, the flexible display may also be folded together, and when the first housing and the second housing are unfolded, the flexible display may also be unfolded together.

The foldable electronic device may include a first printed circuit board disposed in an internal space of a first housing and a second printed circuit board disposed in an internal space of a second housing. The first printed circuit board and the second printed circuit board may be electrically connected to each other through a plurality of conductive connection members (e.g., flexible printed circuit boards (FPCBs)) that pass through the first housing and the second housing.

The foldable electronic device may reduce the areas of the first and second printed circuit boards in order to secure a passage region and a sealing region for the plurality of conductive connection members.

For example, when the areas of the first and second printed circuit boards are reduced, the space for placing electronic components may decrease, and it may be difficult to connect the first and second printed circuit boards using a single conductive connection member.

Various embodiments of the disclosure may provide a foldable electronic device capable of partially expanding the area of a printed circuit board (e.g., the first printed circuit board) by forming a recess or a slit in a portion of a support member (e.g., a first support member) and disposing a portion of the printed circuit board in the recess or the slit.

The technical problems to be addressed by this disclosure are not limited to those described above, and other technical problems not mentioned above may be clearly understood by a person ordinarily skilled in the related art to which the disclosure pertains.

### [Solution to Problem]

According to an embodiment of the disclosure, a foldable electronic device may include a hinge module, a first housing at least partially coupled to a first side of the hinge module and including a first support member and a first printed circuit board, a first through-hole formed in the first support member, a second housing at least partially coupled to a second side of the hinge module and including a second support member and a second printed circuit board, a second through-hole formed in the second support member, and a conductive connection member configured to electrically connect the first printed circuit board and the second printed circuit board through the first through-hole and the second through-hole. According to an embodiment, the first support member may include a recess. According to an embodiment, a portion of the first printed circuit board may be configured to be disposed in the recess.

### [Advantageous Effects of Invention]

According to various embodiments of the disclosure, by disposing a portion of a printed circuit board in a recess (e.g., a groove) or slit formed in a support member, the area of the circuit board may be partially extended, and the first circuit board and the second circuit board may be electrically connected by using a single conductive connection member (e.g., an FPCB).

In addition, various effects that are directly or indirectly identified through this document may be provided.

### [Brief Description of Drawings]

In connection with the description of the drawings, the same or similar components may be denoted by the same or similar reference numerals.
FIG. 1 is a block diagram of an electronic device in a network environment, according to various embodiments of the disclosure.
FIGS. 2A and 2B are front and rear views illustrating a foldable electronic device in an unfolded state according to various embodiments of the disclosure.
FIGS. 3A and 3B are front and rear views illustrating a foldable electronic device in a folded state according to various embodiments of the disclosure.
FIG. 4 is a schematic exploded perspective view illustrating a foldable electronic device according to various embodiments of the disclosure.
FIG. 5 is a schematic rear view illustrating a portion of the configuration of a foldable electronic device in the unfolded state according to an embodiment of the disclosure.
FIG. 6 is a schematic cross-sectional view illustrating a section A-A' of the foldable electronic device of FIG. 5 according to an embodiment of the disclosure.
FIG. 7 is an enlarged view schematically illustrating at least one slit formed in a portion of region B of the foldable electronic device of FIG. 5 according to an embodiment of the disclosure.
FIG. 8 is a schematic view illustrating an extension portion of the first printed circuit board in a portion of region B of the foldable electronic device of FIG. 5 according to an embodiment of the disclosure.
FIG. 9A is a view schematically illustrating a partial configuration of a portion of the first housing of the foldable electronic device disclosed in FIG. 5, according to an embodiment of the disclosure.
FIG. 9B is a view schematically illustrating the configuration a partial configuration of portion C of the first housing disclosed in FIG. 9A, according to an embodiment of the disclosure.
FIG. 9C is a view schematically illustrating a partial configuration in which a first antenna module is removed from portion D of the first housing illustrated in FIG. 9A according to an embodiment of the disclosure.
FIG. 9D is an enlarged view schematically illustrating a partial configuration of portion D of the first housing illustrated in FIG. 9A, according to an embodiment of the disclosure.
FIG. 9E is a view schematically illustrating an elastic member according to an embodiment of the disclosure.

### [Mode for the Invention]

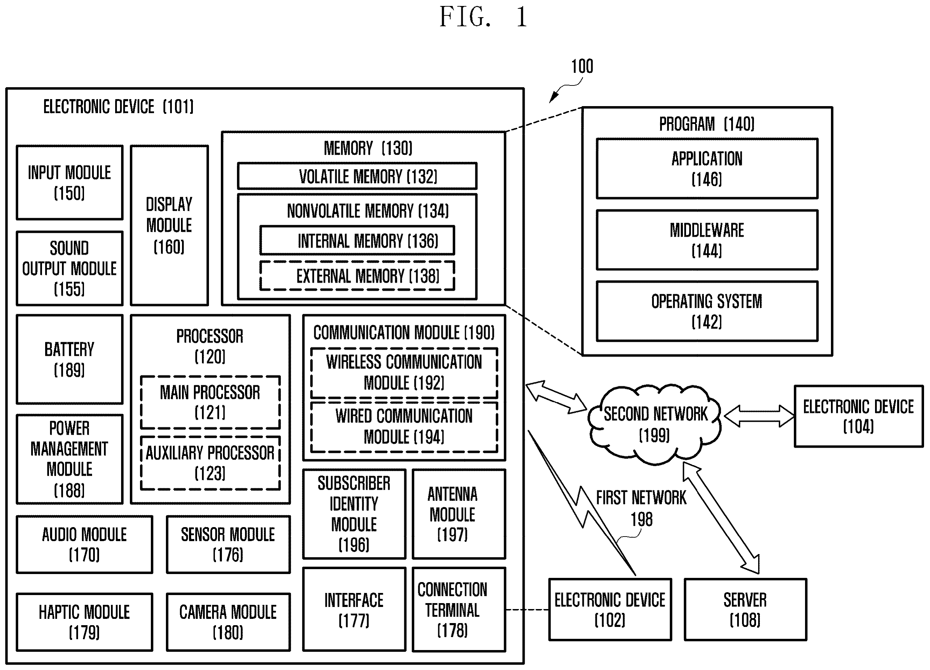

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it denotes that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

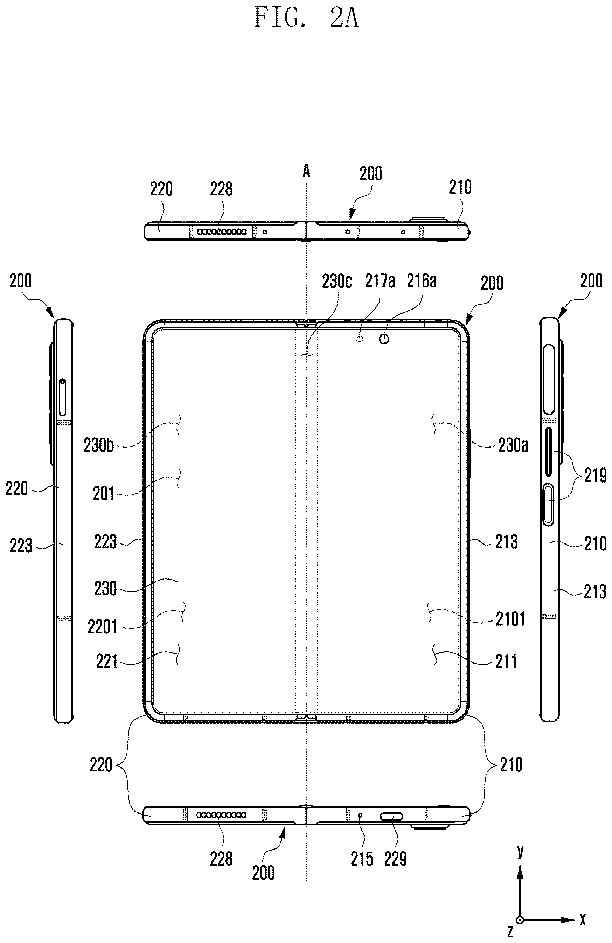

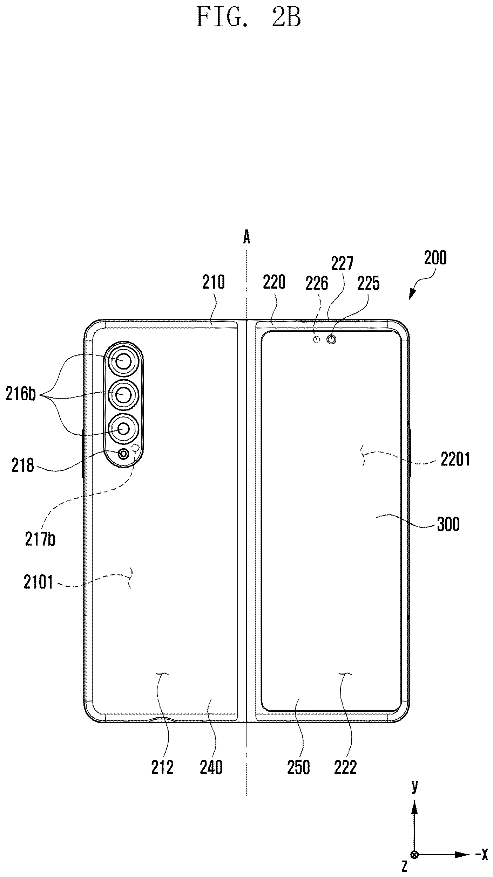

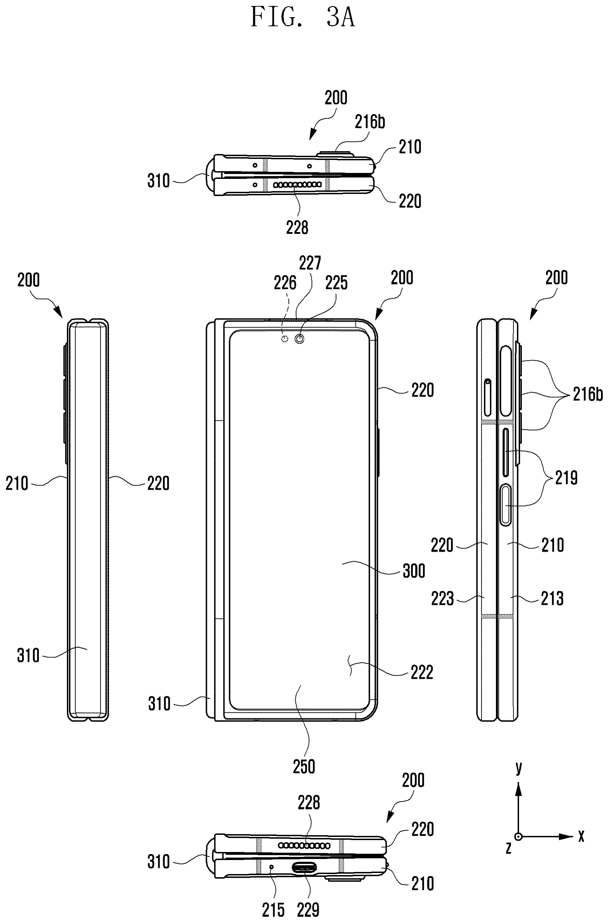

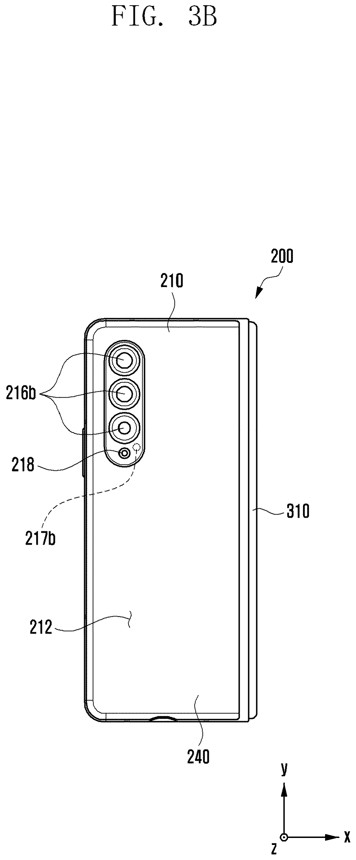

FIGS. 2A and 2B are front and rear views illustrating a foldable electronic device in an unfolded state according to various embodiments of the disclosure. FIGS. 3A and 3B are front and rear views illustrating the foldable electronic device according to various embodiments of the disclosure in a folded state.

According to various embodiments, the embodiments disclosed in FIG. 1 may be included in the embodiments disclosed in FIGS. 2A to 3B. For example, a foldable electronic device 200 illustrated in FIGS. 2A to 3B may include the processor 120, memory 130, input module 150, acoustic output module 155, display module 160, audio module 170, sensor module 176, interface 177, connection terminal 178, haptic module 179, camera module 180, communication module 190, antenna module 197, and/or subscriber identification module 196 illustrated in FIG. 1.

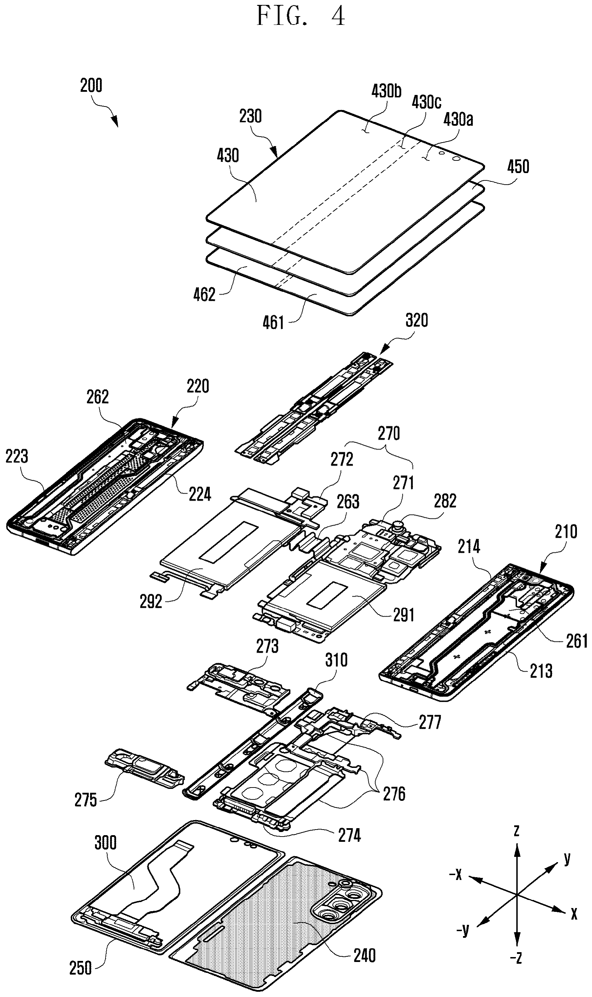

Referring to FIGS. 2A to 3B, the foldable electronic device 200 according to various embodiments of the disclosure may include a pair of housings (e.g., a first housing 210 and a second housing 220) that are rotatably coupled about a folding axis A through a hinge module (e.g., the hinge plate 320 or hinge device of FIG. 4) so as to be foldable relative to each other, a flexible display 230 (e.g., a first display, a foldable display, or a main display) disposed on the pair of housings 210 and 220, and/or a sub-display 300 (e.g., a second display) disposed on the second housing 220.

According to various embodiments, at least a portion of the hinge module (e.g., the hinge plate 320 of FIG. 4) may be positioned to be invisible from the outside through the first housing 210 and the second housing 220, and, in the unfolded state, may be disposed to be invisible from the outside by a hinge cover 310 (e.g., a hinge housing) covering a foldable portion.

Herein, a surface on which the flexible display 230 is disposed may be defined as a front surface (e.g., in the z-axis direction) of the foldable electronic device 200, and the surface opposite to the front surface may be defined as a rear surface (e.g., in the -z-axis direction) of the foldable electronic device 200. A surface surrounding a space between the front surface and the rear surface may be defined as a side surface of the foldable electronic device 200.

According to various embodiments, the pair of housings 210 and 220 may include a first housing 210 and a second housing 220 that are foldably arranged with respect to each other through the hinge module (e.g., the hinge plate 320 of FIG. 4). The pair of housings 210 and 220 are not limited to the shapes and couplings illustrated in FIGS. 2A to 3B, and may be implemented by other shapes or combinations and/or couplings of components. For example, the first housing 210 and the second housing 220 may be disposed on both sides (e.g., in the x-axis direction and the -x-axis direction) with respect to the folding axis A and may have a shape generally symmetrical about the folding axis A. According to various embodiments, the first housing 210 and the second housing 220 may be asymmetrically folded with respect to the folding axis A. The angle or distance between the first housing 210 and the second housing 220 may vary depending on whether the foldable electronic device 200 is in an unfolded state, a folded state, or an intermediate state.

According to various embodiments, when the foldable electronic device 200 is in the unfolded state, the first housing 210 may be connected to a first side (e.g., in the x-axis direction) of the hinge module (e.g., the hinge plate 320 of FIG. 4) and may include a first surface 211 disposed to face the front of the foldable electronic device 200, a second surface 212 facing an opposite direction of the first surface 211, and/or a first side surface member 213 surrounding at least a portion of a first space between the first surface 211 and the second surface 212.

According to various embodiments, when the foldable electronic device 200 is in the unfolded state, the second housing 220 may be connected to a second side (e.g., in the -x-axis direction) of the hinge module (e.g., the hinge plate 320 of FIG. 4) and may include a third surface 221 disposed to face the front of the foldable electronic device 200, a fourth surface 222 facing an opposite direction of the third surface 221, and/or a second side surface member 223 surrounding at least a portion of a second space between the third surface 221 and the fourth surface 222.

According to an embodiment, the first surface 211 may be oriented substantially in the same direction as the third surface 221 in the unfolded state and may at least partially face the third surface 221 in the folded state.

According to various embodiments, the foldable electronic device 200 may further include a recess 201 formed to accommodate the flexible display 230 through structural coupling of the first housing 210 and the second housing 220. The recess 201 may have substantially the same size as the flexible display 230.

According to various embodiments, the hinge cover 310 (e.g., a hinge housing) may be disposed between the first housing 210 and the second housing 220. The hinge cover 310 may be disposed to cover at least a portion of the hinge module (e.g., the hinge plate 320 of FIG. 4). The hinge cover 310 may be covered by a portion of the first housing 210 and the second housing 220 or may be exposed to the outside depending on whether the foldable electronic device 200 is in the unfolded state, the folded state, or the intermediate state.

According to various embodiments, when the foldable electronic device 200 is in the unfolded state, at least a portion of the hinge housing 310 may be covered by the first housing 210 and the second housing 220 to be substantially unexposed to the outside. When the foldable electronic device 200 is in the folded state, at least a portion of the hinge cover 310 may be exposed to the outside between the first housing 210 and the second housing 220. When the first housing 210 and the second housing 220 are in the intermediate state folded with a certain angle, the hinge cover 310 may be at least partially exposed to the outside of the foldable electronic device 200 between the first housing 210 and the second housing 220. For example, a region in which the hinge cover 310 is exposed to the outside may be smaller than that in the completely folded state. The hinge cover 310 may at least partially include a curved surface.

According to various embodiments, when the foldable electronic device 200 is in the unfolded state (e.g., the state of FIGS. 2A and 2B), the first housing 210 and the second housing 220 may form an angle of about 180 degrees, and a first region 230a, a second region 230b, and a folding region 230c of the flexible display 230 may be arranged to be coplanar and oriented in substantially the same direction (e.g., the z-axis direction). In another embodiment, when the foldable electronic device 200 is in the unfolded state, the first housing 210 may rotate relative to the second housing 220 in an out-folding manner such that the second surface 212 and the fourth surface 222 face each other.

According to various embodiments, when the foldable electronic device 200 is in the folded state (e.g., the states of FIGS. 3A and 3B), the first surface 211 of the first housing 210 and the third surface 221 of the second housing 220 may be disposed to face each other. In this case, the first region 230a and the second region 230b of the flexible display 230 may form a narrow angle (e.g., in a range of 0 degrees to about 10 degrees) with each other via the folding region 230c, and may be disposed to face each other.

According to various embodiments, at least a portion of the folding region 230c may be deformed into a curved shape having a predetermined curvature. When the foldable electronic device 200 is in the intermediate state, the first housing 210 and the second housing 220 may be arranged at a certain angle with respect to each other. In this case, the first region 230a and the second region 230b of the flexible display 230 may form an angle greater than that in the folded state and smaller than that in the unfolded state, and the curvature of the folding region 230c may be smaller than that in the folded state and greater than that in the unfolded state.

According to various embodiments, the first housing 210 and the second housing 220 may form an angle that allows them to stop at a predetermined folding angle between the folded state and the unfolded state through the hinge module (e.g., the hinge plate 320 of FIG. 4) (e.g., a free-stop function). In some embodiments, the first housing 210 and the second housing 220 may be continuously operated in an opening direction or a closing direction under pressure with reference to a predetermined inflection angle through a hinge module (e.g., the hinge plate 320 of FIG. 4).

According to various embodiments, the foldable electronic device 200 may include one or more of at least one display (e.g., the flexible display 230 or the sub-display 300) disposed on the first housing 210 and/or the second housing 220, an input device 215, acoustic output devices 227 and 228, sensor modules 217a, 217b, and 226, camera modules 216a, 216b, and 225, key input devices 219, an indicator (not illustrated), or a connector port 229. In some embodiments, at least one of the above-described components may be omitted from the foldable electronic device 200 or at least one other component may be additionally included.

According to various embodiments, the at least one display (e.g., the flexible display 230 or the sub-display 300) may include a flexible display 230 (e.g., a first display) disposed to be supported by the third surface 221 of the second housing 220 through the hinge module (e.g., the hinge plate 320 of FIG. 4) from the first surface 211 of the first housing 210, and a sub-display 300 (e.g., a second display) disposed in an internal space of the second housing 220 to be at least partially visible from the outside through the fourth surface 222. In some embodiments, the sub-display 300 may be disposed in the internal space of the first housing 210 to be visible from the outside through the second surface 212. According to an embodiment, the flexible display 230 may be mainly used when the foldable electronic device 200 is in the unfolded state, and the sub-display 300 may be mainly used when the foldable electronic device 200 is in the folded state. According to an embodiment, in the intermediate state, the foldable electronic device 200 may be controlled such that the flexible display 230 and/or the sub-display 300 may be used based on a folding angle of the first housing 210 and the second housing 220.

According to various embodiments, the flexible display 230 may be disposed in an accommodation space formed by the pair of housings 210 and 220. For example, the flexible display 230 may be disposed in the recess 201 defined by the pair of housings 210 and 220, and may be disposed to occupy substantially most of the front surface of the foldable electronic device 200 in the unfolded state. According to an embodiment, at least a portion of the flexible display 230 may be deformed into a flat or curved surface. The flexible display 230 may include a first region 230a facing the first housing 210, a second region 230b facing the second housing 220, and a folding region 230c that connects the first region 230a and the second region 230b and faces the hinge module (e.g., the hinge plate 320 of FIG. 4). According to an embodiment, the division of regions of the flexible display 230 is merely an exemplary physical division defined by the pair of housings 210 and 220 and the hinge module (e.g., the hinge plate 320 of FIG. 4), and the flexible display 230 may be displayed as a seamless, single full screen through the pair of housings 210 and 220 and the hinge module (e.g., the hinge plate 320 of FIG. 4). The first region 230a and the second region 230b may have a generally symmetrical shape with respect to the folding region 230c or may have a partially asymmetrical shape.

According to various embodiments, the foldable electronic device 200 may include a first rear surface cover 240 disposed on the second surface 212 of the first housing 210 and a second rear surface cover 250 disposed on the fourth surface 222 of the second housing 220. In some embodiments, at least a portion of the first rear surface cover 240 may be formed integrally with the first side surface member 213. In some embodiments, at least a portion of the second rear surface cover 250 may be formed integrally with the second side surface member 223. According to an embodiment, at least one of the first rear surface cover 240 and the second rear surface cover 250 may be made of a substantially transparent plate (e.g., a glass plate including various coating layers, or a polymer plate) or an opaque plate.

According to various embodiments, the first rear surface cover 240 may be made of, for example, coated or colored glass, ceramic, polymer, metal (e.g., aluminum, stainless steel (STS), or magnesium), or an opaque plate such as a combination of two or more of these materials. The second rear surface cover 250 may be made of a substantially transparent plate of, for example, glass or polymer. In this case, the second display 300 may be disposed in the internal space of the second housing 220 to be visible from the outside through the second rear surface cover 250.

According to various embodiments, the input module 215 may include a microphone. In some embodiments, the input module 203 may include multiple microphones disposed so as to be capable of detecting a direction of sound. The input module 215 may include the input module 150 illustrated in FIG. 1.

According to various embodiments, the acoustic output modules 227 and 228 may include speakers. According to an embodiment, the acoustic output modules 227 and 228 may include a call receiver 227 disposed through the fourth surface 222 of the second housing 220 and an external speaker 228 disposed through at least a portion of the second side surface member 223 of the second housing 220. In some embodiments, the input device 215, the acoustic output modules 227 and 228, and the connector 229 may be disposed in spaces of the first housing 210 and/or the second housing 220, and may be exposed to an external environment through at least one hole formed in the first housing 210 and/or the second housing 220. In some embodiments, the holes provided in the first housing 210 and/or the second housing 220 may be commonly used for the input module 215 and the acoustic output modules 227 and 228. In some embodiments, the acoustic output modules 227 and 228 may include a speaker that operates without holes formed in the first housing 210 and/or the second housing 220 (e.g., a piezo speaker). The acoustic output modules 227 and 228 may include the acoustic output module 155 illustrated in FIG. 1.

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the foldable electronic device 200 may include a flash 218 disposed near the second camera module 216b. The flash 218 may include, for example, a light-emitting diode or a xenon lamp. According to an embodiment, the camera modules 216a, 216b, and 225 may include one or more lenses, an image sensor, and/or an image signal processor. In some embodiments, at least one of the camera modules 216a, 216b, and 225 may include two or more lenses (e.g., a wide-angle lens and a telephoto lens) and image sensors, and may be disposed together on one surface of the first housing 210, and/or the second housing 220. The camera modules 216a, 216b, and 225 may include the camera module 180 illustrated in FIG. 1A.

According to various embodiments, the sensor modules 217a, 217b, and 226 may generate electrical signals or data values corresponding to an internal operating state or an external environmental state of the foldable electronic device 200. In an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In some embodiments, the sensor modules 217a, 217b, and 226 may include at least one of a gesture sensor, a grip sensor, a color sensor, an infrared (IR) sensor, an illumination sensor, an ultrasonic sensor, an iris recognition sensor, or a distance detection sensor (e.g., a time-of-flight (TOF) sensor or a light detection and ranging (LiDAR)). The sensor modules 217a, 217b, and 226 may include the sensor module 176 illustrated in FIG. 1A.

According to various embodiments, the foldable electronic device 200 may further include a sensor module (not illustrated), for example, at least one of an atmospheric pressure sensor, a magnetic sensor, a biometric sensor, a temperature sensor, a humidity sensor, a Hall sensor, a six-axis sensor, an acceleration sensor, an angular velocity sensor, or a fingerprint recognition sensor. In some embodiments, the fingerprint recognition sensor may be disposed through at least one of the first side surface member 213 of the first housing 210 and the second side surface member 223 of the second housing 220.

According to various embodiments, the key input device 219 may be disposed to be exposed to the outside through the first side surface member 213 of the first housing 210. In some embodiments, the key input device 219 may be disposed to be exposed to the outside through the second side surface member 223 of the second housing 220. In some embodiments, the foldable electronic device 200 may not include some or all of the key input devices 219, and a key input device 219 not included may be implemented in another form such as a soft key on the at least one display 230 or 300. In another embodiment, a key input device 219 may be implemented using a pressure sensor included in at least one of the displays 230 and 300. A key input device 219 may turn the power of the foldable electronic device 200 on or off, or adjust the volume.

According to various embodiments, the connector port 229 may include a connector (e.g., a USB connector or an interface connector port module (IF module)) for transmitting and/or receiving power and/or data with an external electronic device (e.g., the external electronic devices 102, 104, and 108 of FIG. 1). In some embodiments, the connector ports 229 may be configured to perform a function for transmitting/receiving an audio signal to and from the external electronic device, or may further include a separate connector port (e.g., an ear jack hole) configured to perform an audio signal transmitting/receiving function. The connector port (not illustrated) may include the connection terminal 178 disclosed in FIG. 1.

According to various embodiments, at least one camera module 216a or 225 among the camera modules 216a, 216b, and 225, at least one sensor module 217a or 226 among the sensor modules 217a, 217b, and 226, and/or an indicator may be disposed to be exposed through the at least one display 230 or 300. For example, the at least one camera module 216a or 225, the at least one sensor module 217a or 226, and/or the indicator may be disposed in the internal space of the at least one housing 210 or 300 below the active region (display region) of the at least one display 230 or 300, and may be disposed to come into contact with the external environment through an opening perforated up to the cover member (e.g., a window layer (not illustrated) of the flexible display 230) and/or the second rear surface cover 250 or a transparent region. According to an embodiment, a region in which the at least one display 230 or 300 and the at least one camera module 216a or 225 face each other may be provided as a transmissive region having a predetermined transmittance as a portion of a content display region. According to an embodiment, the transmissive region may have a transmittance ranging from about 5% to about 20%. The transmissive region may include a region overlapping the effective region (e.g., a field-of-view region) of the at least one camera module 216a or 225 through which light that is imaged by an image sensor to generate an image passes. For example, the transmissive region of the at least one display 230 or 300 may each include a region having a lower pixel density than the periphery. For example, the transmission area may be provided in place of an opening. For example, the at least one camera module 216a or 225 may include an under-display camera (UDC) or an under-panel camera (UPC). In another embodiment, some of the camera modules or sensor modules 217a and 226 may be arranged to perform their functions without being visually exposed through the display. For example, in an under-display camera (UDC) structure, a region facing the camera module 216a or 225 and/or the sensor module 217a or 226, which is disposed under the at least one display 230 or 300 (e.g., a display panel), may not require a perforated opening.

FIG. 4 is a schematic exploded perspective view illustrating a foldable electronic device according to various embodiments of the disclosure.

Referring to FIG. 4, the foldable electronic device 200 may include a flexible display 230 (e.g., a first display), a sub-display 300 (e.g., a second display), a hinge plate 320 (e.g., a hinge module, hinge device, or hinge assembly), a pair of support members (e.g., a first support member 261 and a second support member 262), at least one substrate 270 (e.g., a printed circuit board), a first housing 210, a second housing 220, a first rear surface cover 240, and/or a second rear surface cover 250.

According to various embodiments, the flexible display 230 may include a display panel 430 (e.g., a flexible display panel), a support plate 450 disposed below the display panel 430 (e.g., in the -z-axis direction), and a pair of metal plates 461 and 462 disposed below the support plate 450 (e.g., in the -z-axis direction).

According to various embodiments, the flexible display panel 430 may include a first panel region 430a corresponding to the first region of the flexible display 230 (e.g., the first region 230a of FIG. 2A), a second panel region 430b extending from the first panel region 430a and corresponding to the second region of the flexible display 230 (e.g., the second region 230b of FIG. 2A), and a third panel region 430c connecting the first panel region 430a and the second panel region 430b and corresponding to the folding region of the first display 230 (e.g., the folding region 230c of FIG. 2A).

According to various embodiments, the support plate 450 may be disposed between the display panel 430 and the pair of support members 261 and 262. The support plate 450 may be configured to have a material and a shape to provide a flat support structure for the first panel region 430a and the second panel region 430b and a bendable structure for supporting bendability of the third panel region 430c. According to an embodiment, the support plate 450 may be formed of a conductive material (e.g., metal) or a non-conductive material (e.g., polymer or fiber reinforced plastics (FRP)). According to an embodiment, the pair of metal plates 461 and 462 may include a first metal plate 461 disposed between the support plate 450 and the pair of support members 261 and 262 to correspond to at least a portion of the first panel region 430a and the third panel region 430c, and a second metal plate 462 corresponding to at least a portion of the second panel region 430b and the third panel region 430c. According to an embodiment, the pair of metal plates 461 and 462 may be formed of a metal material (e.g., SUS), thereby assisting in providing a ground connection structure and rigidity reinforcement for the flexible display 230.

According to various embodiments, the sub-display 300 may be disposed in a space between the second housing 220 and the second rear surface cover 250. According to an embodiment, the sub-display 300 may be disposed in the space between the second housing 220 and the second rear surface cover 250 to be visible from the outside through substantially an entire area of the second rear surface cover 250.

According to various embodiments, at least a portion of the first support member 261 may be foldably coupled to the second support member 262 through at least one hinge illustrated 320 (e.g., a hinge module). According to an embodiment, the foldable electronic device 200 may include at least one conductive connection member 263 (e.g., a flexible printed circuit board (FPCB)) disposed from at least a portion of the first support member 261 to a portion of the second support member 262 across the hinge plate 320. According to an embodiment, the first support member 261 may extend from or be disposed to be structurally coupled to the first side surface member 213. According to an embodiment, the foldable electronic device 200 may include a first space (e.g., the first space 2101 of FIG. 2A) provided through the first support member 261 and the first rear surface cover 240.

According to various embodiments, the first housing 210 (e.g., a first housing structure) may be configured through coupling of the first side surface member 213, the first support member 261, and the first rear surface cover 240. According to an embodiment, the second support member 262 may extend from the second side surface member 223 or be disposed to be structurally coupled to the second side surface member 223. According to an embodiment, the foldable electronic device 200 may include a second space (e.g., the second space 2201 of FIG. 2A) provided through the second support member 262 and the second rear surface cover 250.

According to various embodiments, the second housing 220 (e.g., a second housing structure) may be configured through coupling of the second side surface member 223, the second support member 262, and the second rear surface cover 250. According to an embodiment, at least a portion of at least one conductive connection member 263 and/or the hinge plate 320 may be disposed to be supported through at least a portion of the pair of support members 261 and 262. According to an embodiment, the at least one conductive connection member 263 may be arranged in a direction crossing the first support member 261 and the second support member 262 (e.g., in the x-axis direction and the -x-axis direction). According to an embodiment, the at least one conductive connection member 263 may be disposed in a direction (e.g., the x-axis direction) substantially perpendicular to the folding axis (e.g., the y-axis or the folding axis A of FIG. 2A).

According to various embodiments, the at least one substrate 270 may include a first substrate 271 (e.g., a first printed circuit board) disposed in the first space 2101 and a second substrate 272 (a second printed circuit board) disposed in the second space 2201. According to an embodiment, the first substrate 271 and the second substrate 272 may include one or more electronic components disposed to implement various functions of the foldable electronic device 200. According to an embodiment, the first substrate 271 (e.g., a first printed circuit board) and the second substrate 272 (e.g., a second printed circuit board) may be electrically connected through at least one conductive connection member 263. In an embodiment, a camera module 282 may be disposed on the first circuit board 271.

According to various embodiments, the foldable electronic device 200 may include one or more batteries 291 and 292. According to an embodiment, the one or more batteries 291 and 292 may include a first battery 291 disposed in the first space 2101 of the first housing 210 and electrically connected to the first substrate 271, and a second battery 292 disposed in the second space 2201 of the second housing 220 and electrically connected to the second substrate 272. According to an embodiment, the first support member 261 and the second support member 262 may further include one or more swelling holes for the first battery 291 and the second battery 292.

According to various embodiments, the first housing 210 may include a first rotational support surface 214. The second housing 220 may include a second rotational support surface 224. According to an embodiment, the first rotational support surface 214 and the second rotational support surface 224 may include curved surfaces corresponding to the curved outer surface of the hinge cover 310. According to an embodiment, when the foldable electronic device 200 is in the unfolded state, the first rotational support surface 214 and the second rotational support surface 224 may cover the hinge cover 310, thereby preventing the hinge cover 310 from being exposed or allowing it to be only partially exposed on the rear surface of the foldable electronic device 200. According to an embodiment, when the foldable electronic device 200 is in the folded state, the first rotational support surface 214 and the second rotational support surface 224 may rotate along the outer surface of the hinge cover 310, thereby allowing the hinge cover 310 to be at least partially exposed on the rear surface of the foldable electronic device 200.

According to various embodiments, the foldable electronic device 200 may include at least one antenna 276 (e.g., an antenna module) disposed in a first space 2201. According to an embodiment, the at least one antenna 276 may be disposed between the first battery 291 and the first rear surface cover 240 in the first space 2201. According to an embodiment, the at least one antenna 276 may include, for example, a near field communication (NFC) antenna, a wireless charging antenna, an ultra-wideband (UWB) antenna, and/or a magnetic secure transmission (MST) antenna. According to an embodiment, the at least one antenna 276 may perform, for example, near field communication with an external device or wireless transmission/reception of power required for charging. According to various embodiments, the at least one antenna 276 (e.g., an antenna module) is not limited to the above-described examples and may include various other types of antennas (e.g., a mmWave antenna) as long as it can perform wireless communication with another electronic device (e.g., the electronic device 102 and/or the electronic device 104 of FIG. 1). For example, an antenna structure may be formed by at least a portion of the first side surface member 213 or the second side surface member 223, and/or a portion or a combination of the first support member 261 and the second support member 262.

According to various embodiments, the foldable electronic device 200 may further include one or more electronic component assembly 274 and 275 and/or additional support members 273 and 277 disposed in the first space 2101 and/or the second space 2201. For example, the one or more electronic component assemblies 274 and 275 may include an interface connector port assembly 274 and a speaker assembly 275. For example, the additional support member 273 may include a speaker assembly 273.

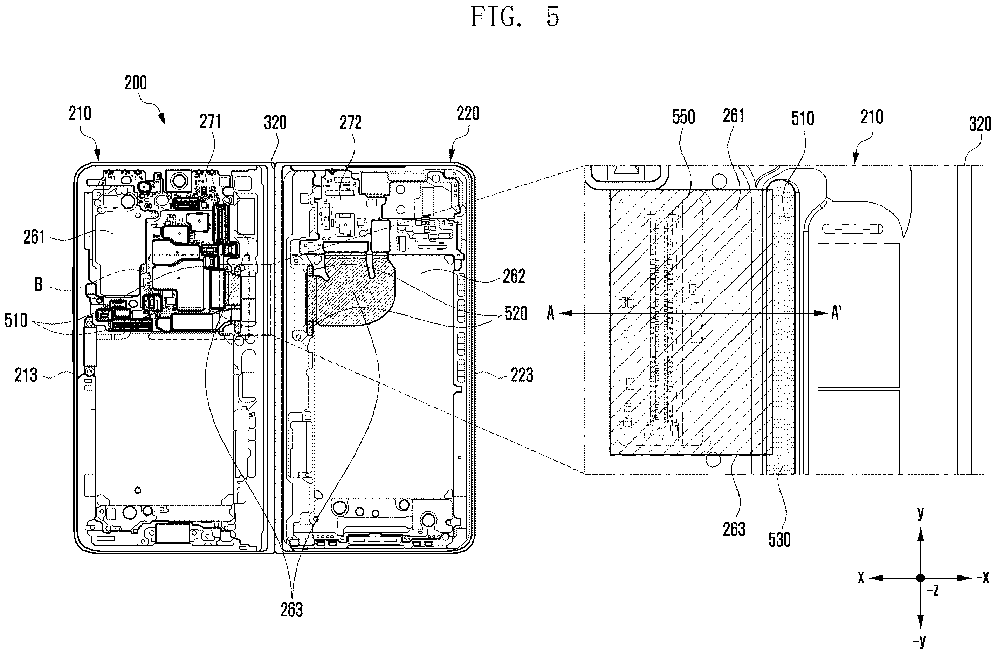

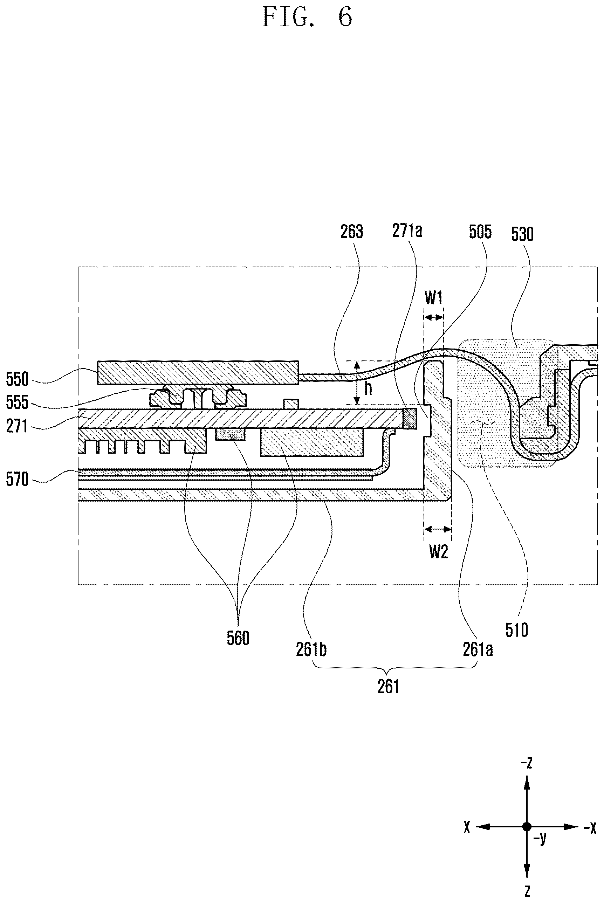

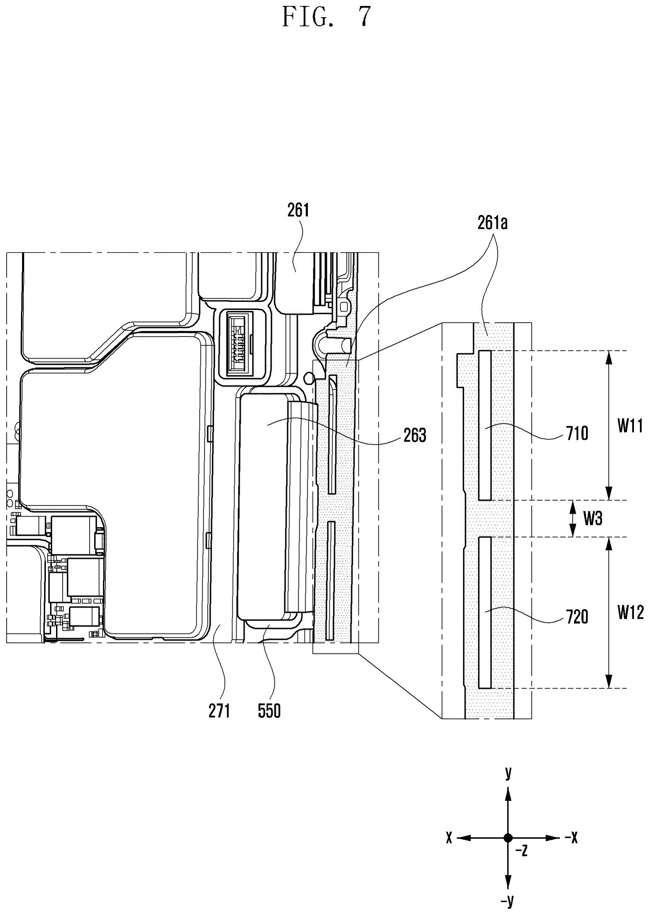

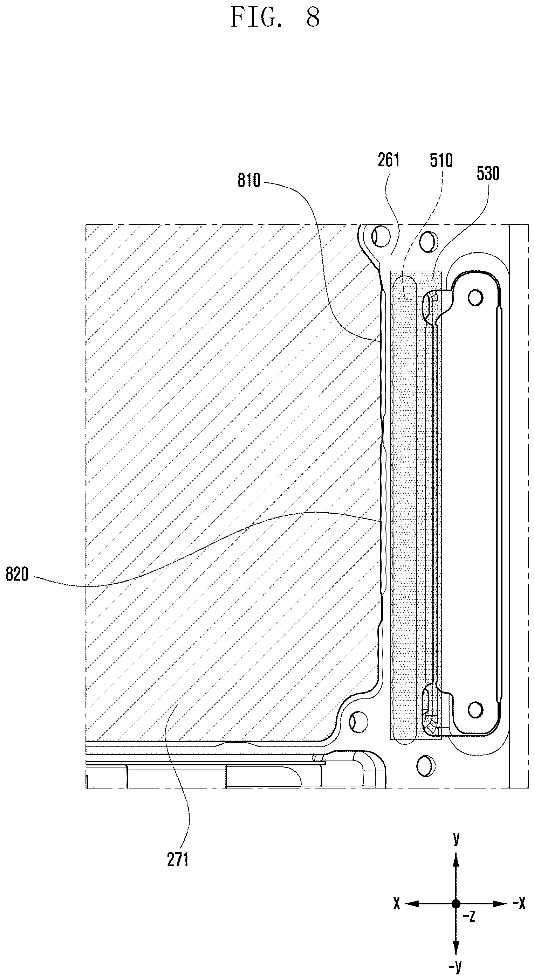

FIG. 5 is a schematic rear view illustrating a portion of the configuration of a foldable electronic device in the unfolded state according to an embodiment of the disclosure. FIG. 6 is a schematic cross-sectional view illustrating a section A-A' of the foldable electronic device of FIG. 5 according to an embodiment of the disclosure. FIG. 7 is an enlarged view schematically illustrating at least one slit formed in a portion of region B of the foldable electronic device of FIG. 5 according to an embodiment of the disclosure. FIG. 8 is a schematic view illustrating an extension portion of the first printed circuit board in a portion of region B of the foldable electronic device of FIG. 5 according to an embodiment of the disclosure.

According to an embodiment, FIG. 5 may be a schematic rear view (e.g., in the -z-axis direction) illustrating a portion of the configurations of the first housing 210 and the second housing 220, from which the first rear surface cover 240 and the second rear surface cover 250 are omitted, when the foldable electronic device 200 of FIG. 2B according to an embodiment of the disclosure is in the unfolded state.

According to various embodiments, the foldable electronic device 200 described below may include the embodiments of the electronic device 101 of FIG. 1 and the foldable electronic device 200 of FIGS. 2A to 4. In the following description of the foldable electronic device 200, components that are substantially identical to those illustrated in FIGS. 1 to 4 are denoted by the same reference numerals, and redundant descriptions of their functions may be omitted.

Hereinafter, embodiments are described, for example, with reference to the foldable electronic device 200, the disclosure is not limited thereto and may be substantially equally applied to other types of electronic devices such as a bar type, a rollable type, a sliding type, a tablet PC, and/or a notebook PC.

In the embodiment related to the foldable electronic device 200 illustrated in FIG. 5, a structure in which the first housing 210 and the second housing 220 are unfolded and folded in a horizontal direction (e.g., in the x-axis direction and the -x-axis direction), but the disclosure is not limited thereto and may be substantially equally applied to a foldable electronic device having a structure in which the housings are unfolded and folded in a vertical direction (e.g., in the y-axis direction and the -y-axis direction).

Referring to FIG. 5, the foldable electronic device 200 may include a first housing 210, a hinge module 320, and the second housing 220.

According to an embodiment, the first housing 210 and the second housing 220 may operate in an unfolded state or a folded state with reference to the hinge module 320 (e.g., the hinge plate of FIG. 4) as illustrated in FIGS. 2A to 3B. The hinge module 320 may rotatably couple the first housing 210 and the second housing 220.

According to an embodiment, the first housing 210 may be coupled at least partially to a first side (e.g., the x-axis direction) of the hinge module 320. The second housing 220 may be coupled at least partially to a second side (e.g., the -x-axis direction) of the hinge module 320. The first housing 210 may be configured to be foldable and unfoldable with the second housing 220 using the hinge module 320. The second housing 220 may be configured to be foldable and unfoldable with the first housing 210 using the hinge module 320.

According to an embodiment, the first housing 210 may include a first support member 261 and a first printed circuit board 271. At least a portion of the first support member 261 may be foldably and unfoldably coupled to the second support member 262 through the hinge module 320. The first support member 261 may extend from the first side surface member 213 or may be disposed to be structurally coupled to the first side surface member 213.

According to an embodiment, the first support member 261 may include a first through-hole 510. The first through-hole 510 may be formed at a predetermined position of the first support member 261 to allow a portion of the conductive connecting member 263 to pass therethrough.

According to an embodiment, the first printed circuit board 271 may be disposed on a rear surface (e.g., in the -z-axis direction) of the first support member 261. The first printed circuit board 271 may be supported by the first support member 261. The first printed circuit board 271 may be disposed in a first space (e.g., the first space 2101 of FIG. 2A) defined by the first support member 261 and the first rear surface cover 240.

According to an embodiment, the second housing 220 may include a second support member 262 and a second printed circuit board 272. At least a portion of the second support member 262 may be foldably and unfoldably coupled to the first support member 261 through the hinge module 320. The second support member 262 may extend from the second side surface member 223 or may be disposed to be structurally coupled to the second side surface member 223.

According to an embodiment, the second support member 262 may include a second through-hole 520. The second through-hole 520 may be formed at a predetermined position of the second support member 262 to allow a portion of the conductive connecting member 263 to pass therethrough.

According to an embodiment, the second printed circuit board 272 may be disposed on a rear surface (e.g., in the -z-axis direction) of the second support member 262. The second printed circuit board 272 may be supported by the second support member 262. The second printed circuit board 272 may be disposed in a second space (e.g., the second space 2201 of FIG. 2A) defined by the second support member 262 and the second rear surface cover 250.

According to various embodiments, the first circuit board 271 and the second circuit board 272 may include at least one electronic component (e.g., the electronic component 560 of FIG. 6) disposed thereon to implement various functions of the foldable electronic device 200. For example, the at least one electronic component (e.g., the electronic component 560 of FIG. 6) may include at least one of the processor 120, memory 130, communication module 190, sensor module 176, and antenna module 197 disclosed in FIG. 1.

According to an embodiment, the first circuit board 271 and the second circuit board 272 may be electrically connected through the conductive connection member 263 (e.g., an FPCB). For example, the conductive connection member 263 may electrically connect the first circuit board 271 and the second circuit board 272 through the first through-hole 510 and the second through-hole 520. For example, the conductive connection member 263 may electrically connect the first circuit board 271 and the second circuit board 272 across the first through-hole 510, at least a portion of the hinge module 320, and the second through-hole 520. For example, the conductive connection member 263 may electrically connect the first circuit board 271 and the second circuit board 272 through connectors 550 respectively disposed on the first circuit board 271 and the second circuit board 272.

According to an embodiment, the conductive connection member 263 may be disposed in a direction crossing the first support member 261 and the second support member 262 (e.g., in the x-axis direction and the -x-axis direction). For example, the conductive connection member 263 may be disposed in a direction substantially perpendicular to a folding axis (e.g., the y-axis or the folding axis A of FIG. 2A) (e.g., in the x-axis direction and the -x-axis direction).

According to an embodiment, a first sealing member 530 may be disposed in a first through-hole 510 through which the conductive connection member 263 passes. The first sealing member 530 may seal a portion of the conductive connection member 263 passing through the first through-hole 510. For example, the first sealing member 530 may seal the first through-hole 510 and a portion of the conductive connection member 263 disposed in the first through-hole 510. The first sealing member 530 may perform waterproof and dustproof functions. For example, the first sealing member 530 may prevent moisture and dust from entering an interior of the foldable electronic device 200 from an exterior of the first housing 210 (e.g., the first support member 261) of the foldable electronic device 200.

According to an embodiment, a second sealing member (not illustrated) may be disposed in the second through-hole 520 through which the conductive connection member 263 passes. The second sealing member may seal a portion of the conductive connection member 263 passing through the second through-hole 520. For example, the second sealing member may seal the second through-hole 520 and a portion of the conductive connection member 263 disposed in the second through-hole 520. The second sealing member may perform waterproof and dustproof functions. For example, the second sealing member may prevent moisture and dust from entering an interior of the foldable electronic device 200 from an exterior of the second housing 220 (e.g., the second support member 262) of the foldable electronic device 200.

Referring to FIG. 6, the first printed circuit board (PCB) 271 may include a connector 550. The connector 550 may be disposed on the first surface (e.g., in the -z-axis direction) of the first printed circuit board 271. For example, the connector 550 may be disposed on the first surface of the first printed circuit board 271 by using a header 555 (e.g., a socket or a connector header). For example, the first printed circuit board 271 and the connector 550 may be electrically connected to each other by using the header 555. The connector 550 may be electrically connected to a portion of the conductive connection member 263.

According to an embodiment, the first printed circuit board 271 (or the second printed circuit board 272) may include at least one electronic component 560. For example, the at least one electronic component 560 may be disposed on the second surface (e.g., in the z-axis direction) of the first printed circuit board 271 (or the second printed circuit board 272).

According to an embodiment, a shielding member 570 may be disposed on the second surface of the first printed circuit board 271 (or the second printed circuit board 272). The shielding member 570 may be disposed between the first printed circuit board 271 (or the second printed circuit board 272) and the first support member 261 (or the second support member 262). The shielding member 570 may shield electrical noise generated from the at least one electronic component 560. For example, the shielding member 570 may be formed of a conductive material. For example, the shielding member 570 may include a shield can.

According to an embodiment, the first support member 261 may include a first portion 261a and a second portion 261b. The first portion 261a and the second portion 261b may be integrally connected. For example, the first portion 261a may be disposed vertically (e.g., in the -z-axis direction) with respect to the first printed circuit board 271. For example, the second portion 261b may be disposed horizontally (e.g., in the x-axis direction) with respect to the first printed circuit board 271. For example, the angle formed between the first portion 261a and the second portion 261b may be about 90°. For example, the angle between the first portion 261a and the second portion 261b may be substantially 90°.

According to an embodiment, the first support member 261 may include a recess 505 (e.g., a groove). The recess 505 may be formed in the first portion 261a of the first support member 261. For example, the recess 505 may include a gap or groove formed by cutting a portion of the first portion 261a. For example, the width of the recess 505 in the horizontal direction (e.g., the x-axis or -x-axis direction) may range from about 0.1 mm to about 0.3 mm. One or more recesses 505 may be formed in the first portion 261a of the first support member 261. The recess 505 may be replaced with a slit (e.g., the first slit 710 or the second slit 720 of FIG. 7). For example, the first portion 261a of the first support member 261 may include a first slit (e.g., the first slit 710 of FIG. 7) and/or a second slit (e.g., the second slit 720 of FIG. 7). A portion (e.g., in the -x-axis direction) of the first printed circuit board 271 may be disposed at a position corresponding to the recess 505. A portion (e.g., in the -x-axis direction) of the first printed circuit board 271 may be disposed in the recess 505. For example, since a portion (e.g., in the -x-axis direction) of the first printed circuit board 271 may be disposed within the recess 505, the area of the first printed circuit board 271 may be extended. For example, the first printed circuit board 271 may include an extension region 271a extending in a direction corresponding to the recess 505 (e.g., in the -x-axis direction). For example, the extension region 271a of the first printed circuit board 271 may be disposed within the recess 505. For example, the recess 505 may be formed to have a width greater than the height of the extension region 271a of the first printed circuit board 271. For example, the recess 505 may accommodate the extension region 271a of the first printed circuit board 271. For example, the extension region 271a of the first printed circuit board 271 may be disposed adjacent to the recess 505. For example, since the extension region 271a of the first printed circuit board 271 may be disposed at a position corresponding to the recess 505 formed in the first portion 261a of the first support member 261, the extension region 271a of the first printed circuit board 271 may be extended by about 0.1 mm to about 0.3 mm.

According to an embodiment, the first portion 261a of the first support member 261 may partially include a stepped structure. The first portion 261a of the first support member 261 may partially include a stepped shape. The first portion 261a of the first support member 261 may have partially different thicknesses. For example, a first width W1 of an upper portion (e.g., in the -z-axis direction) of the first portion 261a may be different from a second width W2 of a lower portion (e.g., in the z-axis direction). For example, the first width W1 of the upper portion (e.g., in the -z-axis direction) of the first portion 261a may range from about 0.3 mm to about 0.4 mm. For example, the second width W2 of the lower portion (e.g., in the z-axis direction) of the first portion 261a may range from about 0.5 mm to about 0.6 mm. For example, the height h of the upper portion (e.g., in the -z-axis direction) of the first portion 261a may range from about 1.0 mm to about 1.2 mm. For example, the upper portion (e.g., in the -z-axis direction) of the first portion 261a may include an upper end of the recess 505 to an upper end (e.g., in the -z-axis direction) of the first portion 261a.

According to an embodiment, the first portion 261a of the first support member 261 may be disposed adjacent to the first through-hole 510. The first portion 261a of the first support member 261 may be disposed adjacent to the first sealing member 530. For example, the first portion 261a of the first support member 261 may be disposed closer to the first through-hole 261 or the first sealing member 530 than the second portion 261b.

Referring to FIG. 7, the first portion 261a of the first support member 261 may include at least one slit. For example, the first portion 261a may include a first slit 710 and/or a second slit 720. The first slit 710 and/or the second slit 720 may be formed in the first portion 261a of the first support member 261. The first slit 710 and/or the second slit 720 may be formed in the recess 505 provided in the first portion 261a of the first support member 261. The first slit 710 and/or the second slit 720 may be formed instead of the recess 505 (e.g., a groove) illustrated in FIG. 6. The first slit 710 and/or the second slit 720 may replace the recess 505 (e.g., a groove) illustrated in FIG. 6. A portion (e.g., in the -x-axis direction) of the first circuit board 271 (e.g., the extension region 271a) may be disposed at a position corresponding to the first slit 710 and/or the second slit 720. A portion (e.g., in the -x-axis direction) of the first circuit board 271 (e.g., the extension region 271a) may be disposed in the first slit 710 and/or the second slit 720. Since a portion (e.g., in the -x-axis direction) of the first circuit board 271 (e.g., the extension region 271a) may be disposed in the first slit 710 and/or the second slit 720, the area of the first circuit board 271 may be extended.

According to an embodiment, the extension region 271a of the first circuit board 271 may be disposed at a position corresponding to the first slit 710 and/or the second slit 720 of the first portion 261a. For example, the first slit 710 may be formed in the y-axis direction of the first portion 261a of the first support member 261. For example, the second slit 720 may be formed in the -y-axis direction of the first portion 261a of the first support member 261. For example, the width W11 of the first slit 710 in the y-axis direction may range from about 7.5 mm to about 7.8 mm. For example, the width W12 of the second slit 720 in the -y-axis direction may range from about 7.5 mm to about 7.8 mm. For example, the widths of the first slit 710 and the second slit 720 may be substantially the same or different. The first slit 710 and the second slit 720 may be spaced apart from each other. For example, a portion of the first portion 261a of the first support member 261 may be disposed between the first slit 710 and the second slit 720. For example, the width W3 of the portion of the first portion 261a disposed between the first slit 710 and the second slit 720 may range from about 1.3 mm to about 1.5 mm.

Referring to FIG. 8, a portion (e.g., in the -x-axis direction) of the first circuit board 271 may include at least a partial extension portion. For example, the first circuit board 271 may include a first extension portion 810 and/or a second extension portion 820. For example, the first extension portion 810 and/or the second extension portion 820 may be formed in the -x-axis direction of the first circuit board 271. The first extension portion 810 and/or the second extension portion 820 may be formed at a position corresponding to the first slit 710 and/or the second slit 720 illustrated in FIG. 7. The first extension portion 810 and/or the second extension portion 820 of the first circuit board 271 may be disposed in the first slit 710 and/or the second slit 720. For example, the first extension portion 810 and/or the second extension portion 820 of the first circuit board 271 may be disposed within the first slit 710 and/or the second slit 720 formed in the first portion 261a of the first support member 261.

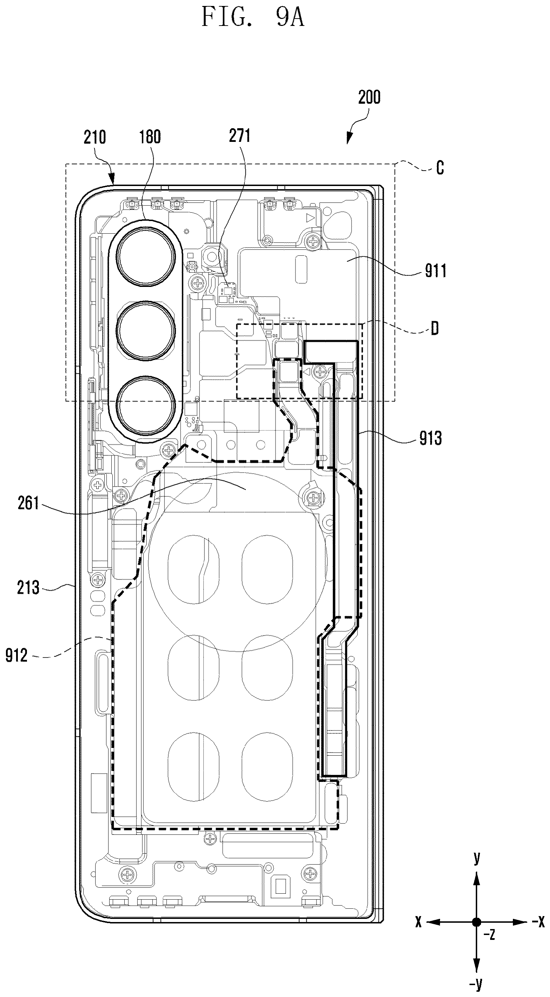

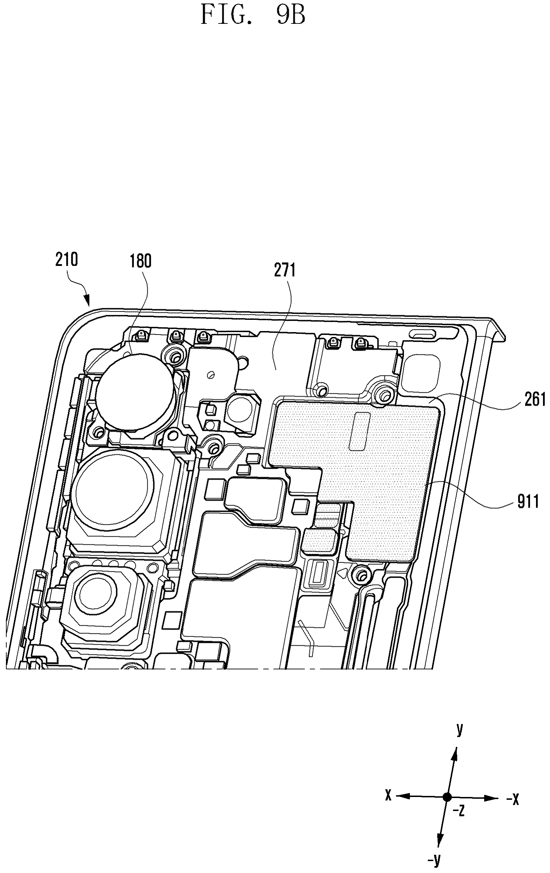

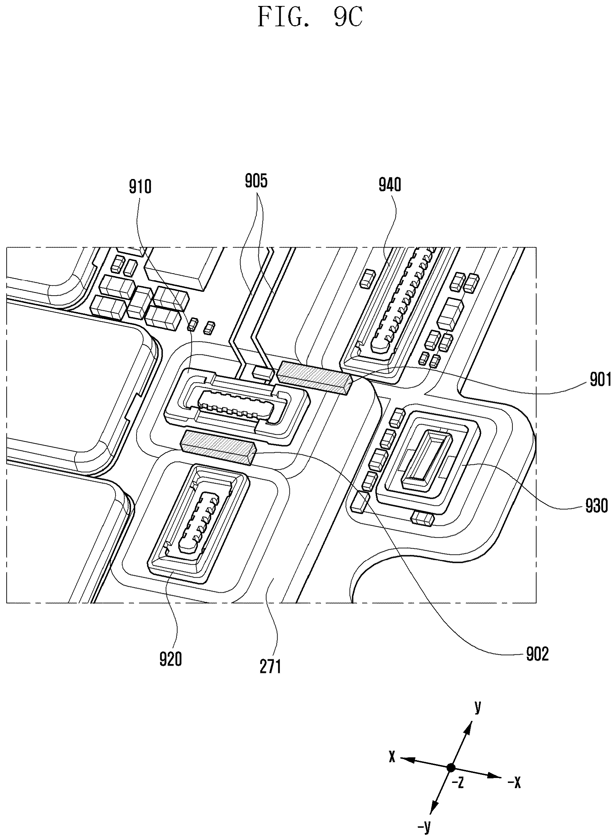

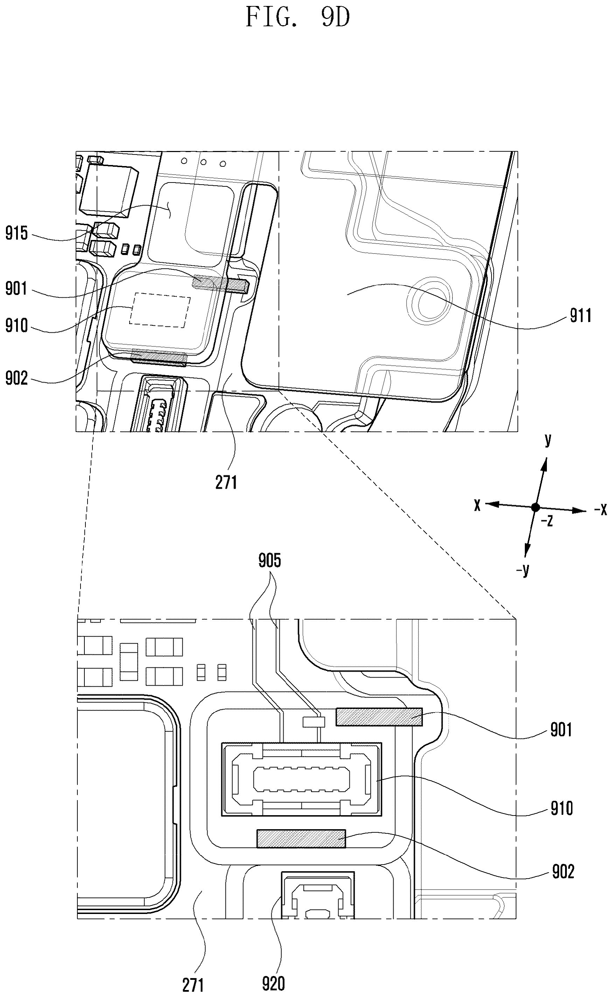

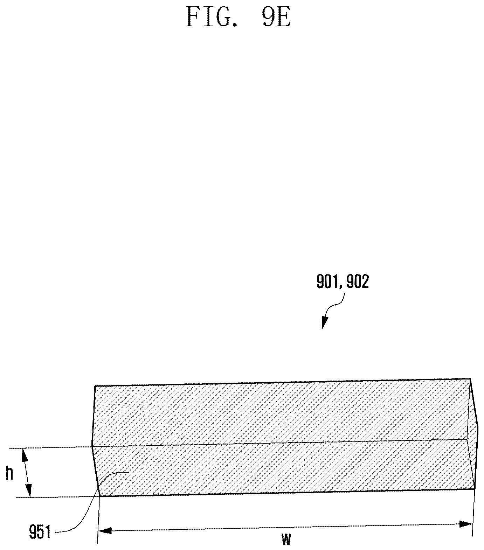

FIG. 9A is a view schematically illustrating a partial configuration of the first housing of the foldable electronic device illustrated in FIG. 5, according to an embodiment of the disclosure. FIG. 9B is a view schematically illustrating a partial configuration of portion C of the first housing illustrated in FIG. 9A, according to an embodiment of the disclosure. FIG. 9C is a view schematically illustrating a partial configuration of portion D of the first housing illustrated in FIG. 9A from which a first antenna module has been removed according to an embodiment of the disclosure. FIG. 9D is an enlarged view schematically illustrating a partial configuration of portion D of the first housing illustrated in FIG. 9A, according to an embodiment of the disclosure. FIG. 9E is a view schematically illustrating an elastic member according to an embodiment of the disclosure.

Referring to FIGS. 9A and 9B, the first housing 210 of the foldable electronic device 200 may include a first antenna module 911, a second antenna module 912, and/or a third antenna module 913 disposed on a rear surface (e.g., in the -z-axis direction) of the first circuit board 271 and/or the first support member 261. For example, the first antenna module 911 may include a UWB (ultra-wideband) antenna. For example, the second antenna module 912 may include at least one of a near field communication (NFC) antenna, a magnetic secure transmission (MST) antenna, and a wireless charging antenna. For example, the third antenna module 913 may include an mmWave antenna.

According to an embodiment, the first antenna module 911 (e.g., a UWB antenna) may be disposed on one side (e.g., in the -x-axis direction) of a camera module 180. For example, the camera module 180 may be disposed in the x-axis direction at an upper portion (e.g., in the y-axis direction) of the first housing 210. The second antenna module 912 (e.g., an NFC antenna) may be disposed below the camera module 180 and the first antenna module 911 (e.g., in the -y-axis direction). The third antenna module 913 (e.g., an mmWave antenna) may be disposed on one side (e.g., in the -x-axis direction) of the second antenna module 912 and below the first antenna module 911 (e.g., in the -y-axis direction). For example, the first antenna module 911, the second antenna module 912, and the third antenna module 913 may be disposed between the first support member 261 and a first rear surface cover (e.g., the first rear surface cover 240 of FIG. 4).

Referring to FIGS. 9C and 9D, the first circuit board 271 may include a first connector 910 (e.g., a UWB antenna connector), a second connector 920 (e.g., an NFC antenna connector), a third connector 930 (e.g., an mmWave antenna connector), and/or a fourth connector 940 (e.g., a digitizer connector).

According to an embodiment, the first connector 910 (e.g., a UWB antenna connector) may be electrically connected to the first antenna module 911 (e.g., a UWB antenna). The second connector 920 (e.g., the NFC antenna connector) may be electrically connected to the second antenna module 912 (e.g., an NFC antenna). The third connector 930 (e.g., the mmWave antenna connector) may be electrically connected to the third antenna module 913 (e.g., an mmWave antenna). The fourth connector 940 (e.g., the digitizer connector) may be electrically connected to a digitizer (not illustrated) of a display module (e.g., the display module 160 of FIG. 1).

According to an embodiment, the first connector 910 (e.g., the UWB antenna connector) may be electrically connected to a processor (e.g., the processor 120 of FIG. 1) and/or a wireless communication module (e.g., the wireless communication module 192 of FIG. 1) disposed on the first circuit board 271 through a signal path 905. The signal path 905 may include at least one microstrip line. The signal path 905 may include at least one radio frequency (RF) wiring line. The signal path 905 may be disposed on the first surface (e.g., in the -z-axis direction) of the first circuit board 271.

According to an embodiment, the first connector 910 may be electrically connected to the first antenna module 911 (e.g., a UWB antenna) through a flexible printed circuit board (FPCB) 915. The flexible printed circuit board 915 (e.g., FPCB) may include an FPCB lead-out portion that electrically connects the first connector 910 and the first antenna module 911 (e.g., a UWB antenna). For example, the flexible printed circuit board (FPCB) 915 may include a structure extending in a direction parallel to the folding axis A (e.g., the folding axis A of FIG. 2A) of the foldable electronic device 200 (e.g., in the y-axis direction or -y-axis direction). For example, the first antenna module 911 (e.g., a UWB antenna) and/or the flexible printed circuit board 915 may be disposed to overlap an upper portion (e.g., in the -z-axis direction) of the first connector 910 and/or the signal path 905.

According to an embodiment, a first elastic element 901 (e.g., a first rubber) and a second elastic element 902 (e.g., a second rubber) may be disposed around the first connector 910. The first elastic element 901 and the second elastic element 902 may be formed of an elastic material (e.g., rubber). For example, the first elastic element 901 and the second elastic element 902 may be mounted on the first circuit board 271 using a surface mounted device (SMD).

According to an embodiment, the first elastic element 901 may be disposed in a first direction (e.g., the y-axis direction) of the first connector 910. The first elastic element 901 may be disposed so as not to overlap the signal path 910. For example, the first elastic element 901 may be disposed at a first position in one direction (e.g., the -x-axis direction) so as not to overlap the signal path 910. For example, the first elastic element 901 may be positioned offset in one direction (e.g., the -x-axis direction) so as not to overlap the signal path 910. For example, at least a portion of the first elastic element 901 may be disposed between the first connector 910 and the fourth connector 940. According to an embodiment, the second elastic element 902 may be disposed at a second position in a second direction (e.g., the -y-axis direction) of the first connector 910. No signal path 910 may be disposed in the second direction (e.g., the -y-axis direction) of the first connector 910. For example, the first elastic element 901 and the second elastic element 902 may be disposed misaligned with each other with respect to the y-axis direction. For example, the second elastic element 902 may be disposed between the first connector 910 and the second connector 920.

According to an embodiment, the first elastic element 901 and the second elastic element 902 may be disposed in a first direction (e.g., on the upper side (in the y-axis direction)) and a second direction (e.g., on the lower side (in the -y-axis direction)) of the first connector 910 so that even when an impact (e.g., a drop) occurs on the foldable electronic device 200, vertical movement of the first connector 910 may be prevented. For example, when an impact (e.g., a drop) occurs on the foldable electronic device 200, the first elastic element 901 and the second elastic element 902 may absorb the shock caused by the vertical movement of the first connector 910 and may prevent the first connector 910 from being detached from the first circuit board 271.

According to various embodiments, although it has been described that the first elastic element 901 and the second elastic element 902 are arranged in the first direction (e.g., on the upper side (in the y-axis direction)) and the second direction (e.g., on the lower side (in the -y-axis direction)) of the first connector 910, the arrangement is not limited thereto and may be placed at other positions around the first connector 910 as long as vertical movement of the first connector 910 can be prevented. For example, additional elastic elements may be disposed in the x-axis and -x-axis directions of the first connector 910 to prevent lateral movement of the first connector 910. For example, the first elastic element 901 and the second elastic element 902 may be integrally formed and may be disposed on the upper, lower, left, and right sides of the first connector 910. In various embodiments, as long as the vertical movement of the first connector 910 can be prevented, the elastic element may be disposed on at least one of the upper, lower, left, or right sides of the first connector 910.

Referring to FIG. 9E, according to an embodiment, the first elastic element 901 or the second elastic element 902 may have a hexahedral shape. For example, the height (h) of the first surface 951 (e.g., a front surface) of the first elastic element 901 or the second elastic element 902 may range from about 0.4 mm to about 0.6 mm. For example, the width (W) of the first surface 951 (e.g., the front surface) of the first elastic element 901 or the second elastic element 902 may range from about 2.3 mm to about 2.5 mm. For example, the height and width of each surface of the first elastic element 901 or the second elastic element 902 may be formed to be substantially the same as the height (h) and width (W) of the first surface 951 (e.g., the front surface). In various embodiments, the first elastic element 901 or the second elastic element 902 is not limited to the above-described hexahedral shape as long as the first elastic element 901 or the second elastic element 902 can prevent movement of the first connector 910, and may be configured in various other shapes.

According to an embodiment of the disclosure, a foldable electronic device 200 may include a hinge module 320, a first housing 210 at least partially coupled to a first side of the hinge module 320 and including a first support member 261 and a first printed circuit board 271, a first through-hole 510 formed in the first support member 261, a second housing 220 at least partially coupled to a second side of the hinge module 320 and including a second support member 262 and a second printed circuit board 272, a second through-hole 520 formed in the second support member 262, and a conductive connection member 263 configured to electrically connect the first printed circuit board 271 and the second printed circuit board 272 through the first through-hole 510 and the second through-hole 520. According to an embodiment, the first support member 261 may include a recess 505, and a portion of the first printed circuit board 271 may be configured to be disposed in the recess 505.

According to an embodiment, the first support member 261 may include a first portion 261a and a second portion 261b, the first portion 261a may be disposed vertically with respect to the first printed circuit board 271, and the second portion 261b may be configured to be disposed horizontally with respect to the first printed circuit board 271.

According to an embodiment, the recess 505 may be formed in the first portion 261a of the first support member 261.

According to an embodiment, the first portion 261a of the first support member 261 may be disposed closer to the first through-hole 510 than the second portion 261b.

According to an embodiment, a first sealing member 530 may be disposed in the first through-hole 510 through which the conductive connecting member 263 passes.

According to an embodiment, a second sealing member may be disposed in the second through-hole 520 through which the conductive connecting member 263 passes.

According to an embodiment, the foldable electronic device 200 may include a shielding member 570 disposed between the first printed circuit board 271 and the first support member 261.

According to an embodiment, the first printed circuit board 271 may include a connector 550, and the connector 550 may be electrically connected to the first printed circuit board 271 using a header 555.

According to an embodiment, the first portion 261a and the second portion 261b may be integrally formed, and the angle between the first portion 261a and the second portion 261b may be substantially 90°.

According to an embodiment, the first printed circuit board 271 may include an extension region 271a extending in a direction corresponding to the recess 505.

According to an embodiment, the recess 505 may include at least one slit 710 or 720.

According to an embodiment, the at least one slit 710 or 720 may be formed in the first portion 261a of the first support member 261.

According to an embodiment, the recess 505 may be replaced with at least one slit 710 or 720.

According to an embodiment, the first printed circuit board 271 may include at least one extension portion 810 or 820 formed at a position corresponding to the at least one slit 710 or 720.

According to an embodiment, the at least one extension portion 810 or 820 may be disposed within the at least one slit 710 or 720.

According to an embodiment, the first printed circuit board 271 may include at least one of a first connector 910, a second connector 920, a third connector 930, and a fourth connector 940.

According to an embodiment, the first connector 910 may be electrically connected to a processor 120 and/or a wireless communication module 192 disposed on the first printed circuit board 271 through a signal path 905.

According to an embodiment, the foldable electronic device 200 may further include a first antenna module 911 disposed on the first printed circuit board 271, and the first connector 910 may be electrically connected to the first antenna module 911 through a flexible circuit board 915.

According to an embodiment, the foldable electronic device 200 may include a first elastic member 901 disposed in a first direction of the first connector 910, and a second elastic member 902 disposed in a second direction of the first connector 910.

According to an embodiment, the first elastic member 901 may be disposed so as not to overlap with the signal path 905.

In the foregoing, the disclosure has been described with reference to various embodiments of the disclosure, but it is evident that changes and modifications made by a person ordinarily skilled in the art to which the disclosure belongs without departing from the technical spirit of the disclosure fall within the scope of the disclosure.

## Claims

1. A foldable electronic device (200) comprising:
a hinge module (320);
a first housing (210) at least partially coupled to a first side of the hinge module (320) and comprising a first support member (261) and a first printed circuit board (271);
a first through-hole (510) formed in the first support member (261);
a second housing (220) at least partially coupled to a second side of the hinge module (320) and comprising a second support member (262) and a second printed circuit board (272);
a second through-hole (520) formed in the second support member (262); and
a conductive connection member (263) configured to electrically connect the first printed circuit board (271) and the second printed circuit board (272) through the first through-hole (510) and the second through-hole (520),
wherein the first support member (261) comprises a recess (505), and a portion of the first printed circuit board (271) is configured to be disposed in the recess (505).

2. The foldable electronic device of claim 1, wherein the first support member (261) comprises a first portion (261a) and a second portion (261b), and
wherein the first portion (261a) is disposed vertically with respect to the first printed circuit board (271), and the second portion (261b) is configured to be disposed horizontally with respect to the first printed circuit board (271).

3. The foldable electronic device of claim 1 or 2, wherein the recess (505) is formed in the first portion (261a) of the first support member (261).

4. The foldable electronic device of claim 2 or 3, wherein the first portion (261a) of the first support member (261) is disposed closer to the first through-hole (510) than the second portion (261b).

5. The electronic device of any one of claims 1 to 4, wherein a first sealing member (530) is disposed in the first through-hole (510) through which the conductive connecting member (263) passes.

6. The electronic device of any one of claims 1 to 5, wherein a second sealing member disposed in the second through-hole (520) through which the conductive connection member (263) passes.

7. The electronic device of any one of claims 1 to 6, further comprising:
a shielding member (570) is disposed between the first printed circuit board (271) and the first support member (261).

8. The foldable electronic device of any one of claims 1 to 7, wherein the first printed circuit board (271) comprises a connector (550), and
wherein the connector (550) is electrically connected to the first printed circuit board (271) using a header (555).

9. The foldable electronic device of any one of claims 2 to 4, wherein the first portion (261a) and the second portion (261b) are integrally formed, and
wherein an angle between the first portion (261a) and the second portion (261b) is substantially 90°.

10. The foldable electronic device of any one of claims 1 to 9, wherein the first printed circuit board (271) comprises an extension region (271a) extending in a direction corresponding to the recess (505).

11. The foldable electronic device of claim 1, wherein the recess (505) comprises at least one slit (710, 720), and
wherein the at least one slit (710, 720) is formed in the first portion (261a) of the first support member (261).

12. The foldable electronic device of claim 11, wherein the first printed circuit board (271) comprises at least one extension portion (810, 820) formed at a position corresponding to the at least one slit (710, 720), and
wherein the at least one extension portion (810, 820) is disposed within the at least one slit (710, 720).

13. The foldable electronic device of any one of claims 1 to 12, wherein the first printed circuit board (271) comprises at least one of a first connector (910), a second connector (920), a third connector (930), and a fourth connector (940), and
wherein the first connector (910) is electrically connected to a processor (120) and/or a wireless communication module (192) disposed on the first printed circuit board (271) through a signal path (905).

14. The foldable electronic device of claim 13, further comprising:
a first antenna module (911) disposed on the first printed circuit board (271),
wherein the first connector (910) is electrically connected to the first antenna module (911) through a flexible circuit board (915).

15. The foldable electronic device of claim 13 or 14, further comprising:
a first elastic member (901) disposed in a first direction of the first connector (910); and
a second elastic member (902) disposed in a second direction of the first connector (910).
